Europäisches Patentamt

European Patent Office

Office européen des brevets

(11) Publication number: **0 492 291 A1**

# EUROPEAN PATENT APPLICATION

(21) Application number: **91121284.3**

(22) Date of filing: **11.12.91**

(51) Int. Cl.⁵: **H03F 3/68**

(30) Priority: **28.12.90 IT 6807890**

(43) Date of publication of application:
**01.07.92 Bulletin 92/27**

(84) Designated Contracting States:
**DE FR GB NL**

(71) Applicant: **SGS-THOMSON
MICROELECTRONICS s.r.l.
Via C. Olivetti, 2
I-20041 Agrate Brianza Milano(IT)**

(72) Inventor: **Murari, Bruno**
Via Ardigò, 1
**I-20052 Monza(IT)**
Inventor: **Cavallari, Eugenio**
Via Palma, 1
**I-20100 Milano(IT)**
Inventor: **Stefani, Fabrizio**
Via Appennini, 16
**I-21010 Cardano al Campo(IT)**

(74) Representative: **Cerbaro, Elena et al**
c/o Studio Torta, Via Viotti 9
**I-10121 Torino(IT)**

(54) **Double bridge amplifier stage for two input signals, particularly for stereo applications.**

(57) An amplifier stage comprising two input terminals (11, 12) each receiving a respective input signal ($V_{INl}$, $V_{INr}$); three amplifiers (15-17) the outputs of which define the output terminals of the stage; and three adding elements (18-20) between the input terminals and the amplifiers. Each adding element (18-20) is input connected to both input terminals (11, 12) and output connected to a respective amplifier (15-17), and effects a linear combination of the input signals ($V_{INl}$, $V_{INr}$) so that separate output signals ($V_{Ol}$, $V_{Or}$) are present between pairs (21,22; 22,23) of the output terminals (21-23), and are respectively correlated to one input signal.

Fig. 1

The present invention relates to a double bridge amplifier stage for two input signals, particularly for stereo applications.

Double bridge structures are commonly employed on integrated audio amplifiers for stereo applications involving the amplification of two separate input signals (right channel (R) and left channel (L)) and independent control of two loudspeakers.

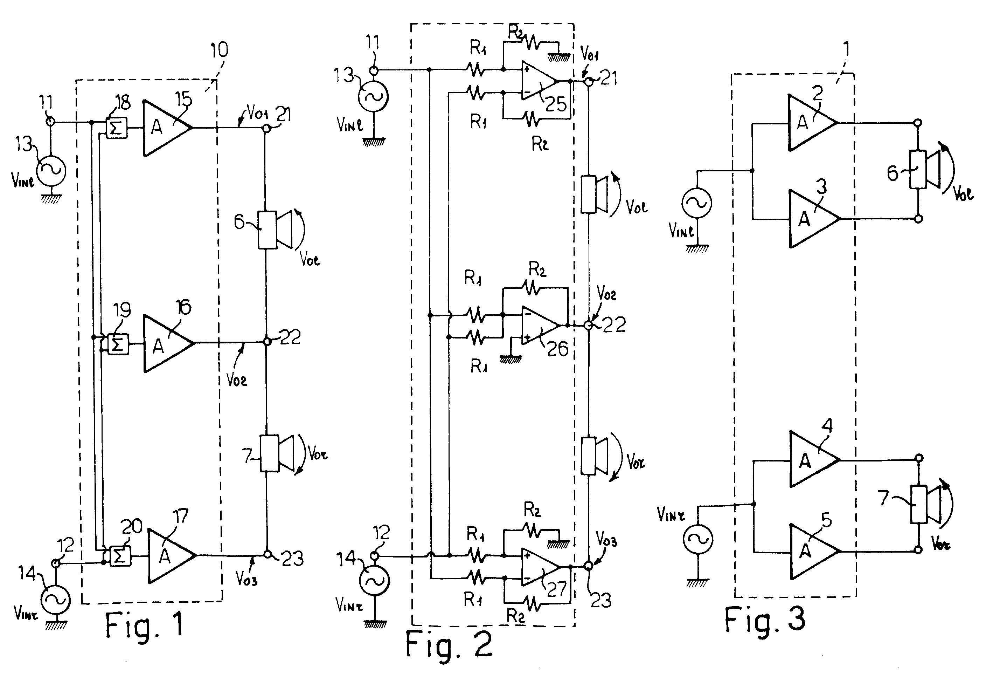

A double bridge structure (indicated as a whole by 1 in the electric diagram in Fig.3) provides for amplifying the two input signals $V_{INl}$ and $V_{INr}$ independently by means of two pairs of power amplifiers 2, 3 and 4, 5.

Amplifiers 2-5 amplify the respective input signal by the same amount (A), but one amplifier (3, 5) in each pair inverts the phase in relation to the other (2, 4) in the same pair, so that the voltage $V_{O1}$, $V_{Or}$ at the terminals of the respective load (loudspeaker 6 or 7) equals:

$$V_{Ol} = A^*V_{INl}-(-A^*V_{INl}) = 2A^*V_{INl'}$$
$$V_{Or} = A^*V_{INr}-(-A^*V_{INr}) = 2A^*V_{INr}$$

The known structure therefore requires four amplifiers for handling the input signals. In view, however, of the current trend towards miniaturization and the cost involved in manufacturing large size structures, considerable advantages are to be afforded by reducing the number of parts of which the stage is composed.

It is an object of the present invention to provide a double bridge amplifier stage for amplifying two input signals as described above, but featuring fewer component parts and, in particular, of compact design. According to the present invention, there is provided a double bridge amplifier stage for two input signals, particularly for stereo applications, as claimed in Claim 1.

A preferred non-limiting embodiment of the present invention will be described by way of example with reference to the accompanying drawings, in which:

Fig.1 shows an operating block diagram of the stage according to the present invention;

Fig.2 shows a simplified electric diagram of one embodiment of the Fig.1 stage;

Fig.3 shows an operating block diagram of a known stage.

Number 10 in Fig.1 indicates an amplifier stage having two input terminals 11, 12 connected to respective sources 13, 14 generating respective input signals $I_{INl'}$ $I_{INr}$. Stage 10 comprises three adding elements 18, 19, 20, and three identical amplifiers 15, 16, 17 for ensuring the same amount of amplification (A). Each adding element 18, 19, 20 presents two inputs respectively connected to terminals 11, 12 so that all three adding elements receive both input signals $V_{INl}$, $V_{INr}$. Each adding element 18, 19, 20 provides for effecting a linear combination of input signals $V_{INl}$ and $V_{INr}$, which combination is supplied to the respective inputs of amplifiers 15-17. The outputs of amplifiers 15-17 define three stage output terminals 21, 22, 23 between which are connected two loudspeakers 6, 7, loudspeaker 6 between terminals 21 and 22, and loudspeaker 7 between terminals 22 and 23.

Therefore, if $V_{O1}$, $V_{O2}$ and $V_{O3}$ are the respective voltage output signals of amplifiers 15-17 at terminals 21, 22, 23; and a,b - c,d - e,f are the coefficients of the linear combinations of input signals $V_{INl}$ and $V_{INr}$ effected respectively by adding elements 18, 19, 20; the output voltages $V_{Ol}$, $V_{Or}$ at the terminals of loudspeakers 6 and 7 equal:

$$V_{Ol} = V_{O1}-V_{O2} = A^*(a^*V_{IN1}+b^*V_{INr})-A^*(c^*V_{IN1}+d^*V_{INr}) =$$
$$= A^*V_{IN1}^*(a-c)+A^*V_{INr}^*(b-d),$$
$$V_{Or} = V_{O3}-V_{O2} = A^*(e^*V_{IN1}+f^*V_{INr})-A^*(c^*V_{IN1}+d^*V_{INr}) =$$
$$= A^*V_{IN1}^*(e-c)+A^*V_{INr}^*(f-d).$$

Therefore, by selecting the linear combination coefficients so that:

a-c = 2; b-d = 0; e-c = 0; f-d = 2,     (1)

this gives:

$$V_{Ol} = V_{O1}-V_{O2} = 2A^*V_{INl} \text{ and}$$
$$V_{Or} = V_{O3}-V_{O2} = 2A^*_{INr},$$

that is, the same function as the double bridge configuration of the known solution in Fig.3.

As (1) constitutes a series of four equations of six unknown quantities, two degrees of freedom exist in the selection of the coefficients, and therefore two infinite numbers of combinations.

Stage 10 performs a first linear combination of the input signals, which are amplified using only three power amplifiers; and a second linear combination at load (loudspeaker) level to subtract the respective components of the right signal $V_{INr}$ (loudspeaker 6) and left signal $V_{INl}$ (loudspeaker 7), so that the loudspeakers only receive the respective left and right signals amplified as required.

One embodiment of the Fig.1 diagram is shown by way of example in Fig.2, wherein resistors $R_1$ present the same value, as do resistors $R_2$.

As shown in Fig.2, amplifiers 15-17 and adding elements 18-20 consist of three operational amplifiers 25, 26, 27, connected respectively in differential, inverting-adding, and differential amplifier configurations. In more detail, operational amplifier 25 presents its non-inverting input connected via a first resistor $R_1$ to terminal 11, and via a first resistor $R_2$ to ground (reference potential line), and its inverting input connected via a second resistor $R_1$ to terminal 12, and via a second resistor $R_2$ to its own output.

Operational amplifier 26 presents its inverting input connected via a third resistor $R_1$ to terminal 11, via a fourth resistor $R_1$ to terminal 12, and via a third resistor $R_2$ to its own output, and its non-inverting input connected to ground. Operational amplifier 27 presents its non-inverting input connected via a fifth resistor $R_1$ to terminal 12, and via a fourth resistor $R_2$ to ground, and its inverting input connected via a sixth resistor $R_1$ to terminal 11, and via a fifth resistor $R_2$ to its own output.

The outputs of operational amplifiers 25-27 define the stage output terminals 21-23.

The output voltages of operational amplifiers 25-27 are therefore:

$$V_{O1} = (R_2/R_1)^*(V_{INl}-V_{INr});$$
$$V_{O2} = -(R_2/R_1)^*V_{INl} + V_{INr});$$
$$V_{O3} = (R_2/R_1)^*(V_{INr}-V_{INl})$$

and the voltages at the terminals of loudspeakers 6 and 7:

$$V_{Ol} = V_{O1}-V_{O2} = 2(R_2/R_1)^*V_{INl} \text{ and}$$
$$V_{Or} = V_{O3}-V_{O2} = 2(R_2/R_1)^*V_{INr},$$

that is, as produced by respectively amplifying the separate left and right signals.

The advantages of the amplifier stage in Fig.s 1 and 2 substantially derive from reducing the number of power amplifiers employed. In fact, as demonstrated above, the linear combination of the input signals enables the production of monolithically integratable audio amplifiers for stereo applications, providing for the same performance as the known double bridge configuration in Fig.3, but featuring three instead of four power amplifiers, thus greatly reducing the size of the silicon wafer in which the stage is integrated.

Moreover, said reduction in the number of power amplifiers is achieved quite simply, with no complex circuitry required, in that, as shown in the Fig.2 embodiment, said combination is achieved by simply selecting the most appropriate configuration of the operational amplifiers, and by appropriate sizing of the components, integration of which is both straightforward and fully controllable, thus ensuring a high degree of reliability of the stage itself.

To those skilled in the art it will be clear that changes may be made to the stage as described and illustrated herein without, however, departing from the scope of the present invention. The Fig.2 embodiment, in fact, is purely indicative, and allows an infinite number of variations, as confirmed also by equations (1).

## Claims

1. A double bridge amplifier stage for two input signals, particularly for stereo applications, comprising a number of amplifying elements (15-17) connected to two input terminals (11, 12) each receiving a respective input signal ($V_{INl}$, $V_{INr}$), said amplifying elements being connected to output terminals (21-23) for connection to two loads (6, 7) each supplied with a respective separate output signal ($V_{Ol}$, $V_{Or}$); characterised by the fact that it comprises adding means (18-20) between said input terminals (11, 12) and said amplifying elements (15-17), for supplying each said amplifying element with a linear combination of both said input signals ($V_{INI}$, $V_{INr}$), so that said separate output signals ($V_{OI}$, $V_{Or}$) are present between pairs (21,22; 22,23) of said output terminals (21-23), and are correlated respectively to one said input signal.

2. A stage as claimed in Claim 1, characterised by the fact that it comprises three adding elements (18-20), three amplifying elements (15-17), and three output terminals (21-23); each said adding element presenting a first and second input and an output; said first inputs of said adding elements being connected to a first (11) of said input terminals (11, 12); said second inputs of said adding elements being connected to a second (12) of said input terminals; and the output of each said adding element being connected to the input of a respective amplifying element; each said amplifying element (15-17) presenting an output defining one of said output terminals (21-23); and said loads (6, 7) being connectable respectively between said first (21) and second (22) output terminal, and between said second (22) and third (23) output terminal.

3. A stage as claimed in Claim 2, characterised by the fact that said adding elements (18-20) comprise means for effecting a linear combination of said input signals ($V_{INI}$, $V_{INr}$), each according to a respective pair of coefficients a,b; c,d; e,f, so that:

a-c = 2; b-d = 0; e-c = 0; f-d = 2.

4. A stage as claimed in one of the foregoing Claims from 1 to 3, characterised by the fact that each said amplifying means (15-17) comprises an operational amplifier (25-27) having an inverting input and a non-inverting input connected to said input terminals (11, 12), and an output defining one of said output terminals (21-23).

5. A stage as claimed in Claim 4, characterised by the fact that said amplifying means (15-17) comprise a first (25) and second (27) operational amplifier connected in a differential configuration, and a third operational amplifier (26) connected in an inverting-adding configuration.

6. A stage as claimed in Claim 5, characterised by the fact that said first operational amplifier (25) presents its non-inverting input connected via a first resistor ($R_1$) to said first input terminal (11) and via a second resistor ($R_2$) to a reference potential line, and its inverting input connected via a third resistor ($R_1$) to said second input terminal (12) and via a fourth resistor ($R_2$) to its own output; said second operational amplifier (27) presents its non-inverting input connected via a fifth resistor ($R_1$) to said second input terminal and via a sixth resistor ($R_2$) to said reference potential line, and its inverting input connected via a seventh resistor ($R_1$) to said first input terminal and via an eighth resistor ($R_2$) to its own output; said third operational amplifier (26) presents its inverting input connected via a ninth resistor ($R_1$) to said first input terminal, via a tenth resistor ($R_1$) to said second input terminal, and via an eleventh resistor ($R_2$) to its own output, and its non-inverting input connected to said reference potential line; and by the fact that the outputs of said first, third and second operational amplifiers (25-27) respectively define said first, second and third output terminals (21-23).

7. A stage as claimed in Claim 6, characterised by the fact that said first, third, fifth, seventh, ninth and tenth resistors present the same resistance ($R_1$), and said second, fourth, sixth, eighth and eleventh resistors present the same resistance ($R_2$).

Fig. 3

Fig. 2

Fig. 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | GB-A-2 132 848 (TOKYO SHIBAURA DENKI K.K.)<br>* page 2, line 15 - page 4, line 1; figure 1 *<br>* page 11, line 2 - page 12, line 29; figure 15 *<br>----- | 1-7 | H03F3/68 |

TECHNICAL FIELDS SEARCHED (Int. Cl.5)

H03F

The present search report has been drawn up for all claims

| Place of search | Date of completion of the search | Examiner |
|---|---|---|
| THE HAGUE | 26 MARCH 1992 | TYBERGHIEN G.M. |

EPO FORM 1503 03.82 (P0401)